# EUROPEAN PATENT APPLICATION

(11) **EP 4 636 476 A2**
(43) Date of publication of application: **22.10.2025**
(21) Application number: 25167885.0
(22) Date of filing: 02.04.2025
(51) Int. Cl.: G03F 1/22, G03F 1/26, G03F 1/48

(54) **REFLECTIVE PHOTOMASK BLANK, AND METHOD FOR MANUFACTURING REFLECTIVE PHOTOMASK**

(30) Priority: 17.04.2024 JP 2024066926
(71) Applicant: SHIN-ETSU CHEMICAL CO., LTD.,, Chiyoda-ku, Tokyo 1000005 (JP)
(72) Inventor: SAKURAI, Keisuke, Joetsu-shi, 9428601 (JP)
(74) Representative: Mewburn Ellis LLP

(57) **Abstract**

A reflective photomask blank including a substrate, a multilayer reflection film on the substrate that reflects exposure light being light in extreme ultraviolet range, a protection film on the multilayer reflection film, a light absorbing film in contact with the protection film that absorbs the exposure light, and a hard mask film in contact with the light absorbing film is provided. The protection film consists of a first layer provided at the substrate-side, and a second layer provided at the side remote from the substrate, the second layer is composed of a material resistant to dry etching capable of etching of the light absorbing film, the light absorbing film has a phase shift function and is formed of a single layer or multiple layers, and the single layer and each layer constituting the multiple layers are composed of a material containing ruthenium as a main component.

## Description

### TECHNICAL FIELD

The present invention relates to a method for manufacturing a reflective photomask that is used in manufacturing semiconductor devices and others, and a reflective photomask blank that is used as a material for manufacturing the reflective photomask.

### BACKGROUND

It is required that projection exposure has high pattern resolution in accordance with miniaturization of semiconductor devices, particularly, in accordance with high integration of large-scale integrated circuits. Thus, as a photomask, a phase shift mask has been developed as a means for improving the resolution of a transfer pattern. A principle of phase shift function is that, by adjusting so as to invert a phase of transmitted light that has been passed through an opening of a phase shift film of the photomask by about 180 degrees with respect to a phase of transmitted light that has been passed through the phase shift film portion adjacent to the opening, interference between the transmitted lights reduces a light intensity at the boundary of the opening and the portion adjacent to the opening. As a result, resolution of a transfer pattern and depth of focus are improved. A photomask utilizing this principle is generally called a phase shift mask.

A most common phase shift mask blank (transmissive phase shift mask blank) that is used as a material for manufacturing a conventional phase shift mask (transmissive phase shift mask) has a structure in which a phase shift film is laminated on a transparent substrate such as a glass substrate, and a film composed of a material containing chromium (Cr) are laminated on the phase shift film. The phase shift film usually has a phase shift of 175 to 185 degrees and a transmittance of about 6 to 30% with respect to exposure light, and a mainstream phase shift film is a film composed of a material containing silicon (Si), particularly a material containing molybdenum (Mo) and silicon (Si). Further, a film composed of a material containing chromium (Cr) is adjusted so as to have a thickness that provides a desired optical density together with the phase shift film, and generally, the film composed of a material containing chromium (Cr) is used as a light-shielding film, and is also used as an etching mask (hard mask) in etching of the phase shift film.

In particular, a general method for manufacturing a phase shift mask from a phase shift mask blank in which a phase shift film composed of a material containing silicon (Si), and a light-shielding film composed of a material containing chromium (Cr) are formed in this order on a transparent substrate by patterning the phase shift film is as follows. First, a resist film is formed on the light-shielding film composed of a material containing chromium (Cr) of the phase shift mask blank, and a resist pattern is formed by drawing a pattern onto the resist film by light or an electron beam, and developing. Next, the light-shielding film composed of a material containing chromium (Cr) is dry-etched with using the resist pattern as an etching mask, and a chlorine-based gas to form a pattern of the light-shielding film. Further, the phase shift film composed of a material containing silicon (Si) is dry-etched with using the pattern of the light-shielding film as an etching mask, and a fluorine-based gas to form a pattern of the phase shift film. Then, the resist pattern is removed, and the pattern of the light-shielding film is removed by dry etching using a chlorine-based gas.

In this case, the light-shielding film is remained at the portion outside of the portion in which the pattern (circuit pattern) of the phase shift film is formed, and a light-shielding portion (light-shielding pattern) having an optical density of not less than 3 in the combination of the phase shift film and the light-shielding film is provided at the outer periphery portion of the phase shift mask. This is to prevent irradiation of leaked exposure light at the outer periphery portion of the phase shift mask to the resist film formed on adjacent chips in the wafer through the portion located outside of the circuit pattern in transferring the circuit pattern to a wafer by a wafer exposure device. In a general method for forming such a light-shielding pattern, after forming a pattern of the phase shift film and removing a resist pattern, a resist film is anew formed and a resist pattern remained on the outer periphery portion of the phase shift mask is formed by drawing a pattern and developing. Then, a film composed of a material containing chromium (Cr) is etched with using the resist pattern as an etching mask to form the light-shielding film remained on the outer periphery portion of the phase shift mask.

A mainstream etching for a phase shift mask that requires highly accurate pattern formation is dry etching using gas plasma. Dry etching using a chlorine-based gas (chlorine-based dry etching) is used for a film composed of a material containing chromium (Cr), and dry etching using a fluorine-based gas (fluorine-based dry etching) is used for a film containing silicon (Si) or a film containing molybdenum (Mo) and silicon (Si). Particularly, it is known that, in chlorine-based dry etching for a film composed of a material containing chromium (Cr), chemical reactivity and etching rate are increased by dry etching using an oxygen-containing chlorine-based gas being an etching gas of chlorine gas (Cl₂ gas) mixed with 10 to 25 vol% of oxygen gas (O₂ gas).

According to miniaturization of circuit patterns, circuit patterns of a phase shift mask also require a technique for fine pattern formation. Particularly, assist patterns of line patterns, which assist resolution of main patterns of the phase shift mask, are needed to form smaller than the main patterns so as not to be transferred onto a wafer when circuit patterns are transferred onto the wafer by a wafer exposure device. In a phase shift mask of the generation in which a half pitch of line and space patterns of the circuits on the wafer is 10 nm, a line width of the assist patterns of the line patterns of the circuit on the phase shift mask is required to be about 40 nm.

On the other hand, a chemically amplified resist is generally used as a resist. A chemically amplified resist that can form fine patterns consists of a base resin, an acid generator, a surfactant and others, and can be applied to many reactions in which the acid generated by exposure acts as a catalyst. Therefore, the chemically amplified resist can have high sensitivity, and by using a chemically amplified resist, it is possible to form a fine pattern having a line width of not more than 0.1 µm in a mask pattern such as a phase shift film pattern. The resist is applied onto the photomask blank by spin coating using a resist coater.

However, the resist has been no longer able to respond to the miniaturization of circuit patterns. A thickness of the resist film used for an advanced phase shift mask blank is 100 to 150 nm. The reason why it is difficult to form a finer assist pattern on a phase shift mask is that since the resist pattern for forming the assist pattern formed on a light-shielding film composed of material containing chromium (Cr) has a high height-to-width ratio (aspect ratio), in developing process for forming the resist pattern, the resist pattern collapses due to impact of a developing solution or impact of pure water during rinsing.

It is considered to reduce a height-to-width ratio (aspect ratio) of the resist pattern for reducing influence of the impact of the developing solution or the impact of pure water during rinsing. In that case, the resist film will be thinned. However, when the resist film is thin, if the resist film is lost during dry etching of the light-shielding film composed of a material containing chromium (Cr), pinhole defects are generated in the light-shielding film composed of a material containing chromium (Cr). As a result, when a phase shift film is dry-etched with using a light-shielding film composed of a material containing chromium (Cr) as an etching mask, plasma in etching of the phase shift film reaches to the phase shift film through the pinholes, pinhole defects are formed also in the phase shift film. Accordingly, a phase shift mask that functions in wafer manufacturing normally cannot be manufactured.

To solve this problem, a hard mask film composed of a material containing silicon (Si) and being free of chromium (Cr) has been further provided on the light-shielding film composed of a material containing chromium (Cr). In this case, the hard mask film composed of a material containing silicon (Si) and being free of chromium (Cr) is a thin film having a thickness of 5 to 15 nm, and a thickness of the resist film formed on the hard mask film can be relatively thinned with a thickness of 80 to 110 nm.

In the case that the light-shielding film composed of a material containing chromium (Cr) is dry-etched with using an oxygen-containing chlorine-based gas, the etching must be performed for an etching-clear-time in which the light-shielding film composed of a material containing chromium (Cr) disappears, added with an over-etching that is 100 to 300% of the etching-clear-time. This is because the oxygen-containing chlorine-based dry etching is isotropic etching dominated by chemical components. Therefore, a desired pattern width is not stably formed since a pattern of the light-shielding film composed of a material containing chromium (Cr) is insufficiently etched at the boundary with the phase shift film, resulting in a trailing shape.

Further, since the oxygen-containing chlorine-based dry etching is isotropic etching dominated by chemical components, oxygen-containing chlorine-based plasma moves in vertical and horizontal directions to the substrate, resulting in side etching in the pattern of the light-shielding film composed of a material containing chromium (Cr). Thus, to obtain uniform CD (Critical Dimension), which is a pattern line width, over the entire surface of the light-shielding film composed of a material containing chromium (Cr), it is necessary to obtain an equivalent amount of side etching over the entire surface of the light-shielding film composed of a material containing chromium (Cr). For this purpose, long-time dry etching is required until the amount of side etching saturates (reaches to saturated state) and stabilizes.

On the other hand, in the case that the phase shift film composed of a material containing silicon (Si) is dry-etched with using a fluorine-based gas, the etching is performed for an etching-clear-time in which the phase shift film composed of a material containing silicon (Si) disappears, added with an over-etching that is up to about 20% of the etching-clear-time (for example, short over-etching of 1 to 6 seconds). By the dry etching, the phase shift is adjusted to a phase shift of 175 to 185 degrees with respect to exposure light with slightly etching the transparent substrate in contact with the phase shift film. In this case, generally, the phase shift film composed of a material containing silicon (Si) is set to have an initial phase shift of 175 to 179 degrees, and the desired phase shift, i.e., 175 to 185 degrees is obtained by carving the transparent substrate by the over-etching.

Short-time over-etching can provide desired properties in fluorine-based dry etching because the fluorine-based dry etching is anisotropic etching dominated by physical components. Therefore, a trailing shape is not formed to the pattern of the phase shift film composed of a material containing silicon (Si) at the boundary with the substrate. Further, since fluorine-based plasma moves in vertical direction to the substrate surface, and the CD of the light-shielding film composed of a material containing chromium (Cr) that functions as an etching mask is faithfully duplicated, long-time over-etching is not necessary.

Fluorine-based dry etching is anisotropic etching dominated by physical components, thus, an amount of loss of the resist is generally larger than chlorine-based dry etching. Therefore, a resist film for forming a pattern of a hard mask film composed of a material containing silicon (Si) must be suitably thick. However, since a hard mask film composed of a material containing silicon (Si) acts as an etching mask when a light-shielding film composed of a material containing chromium (Cr) is dry-etched with using a chlorine-based gas, and has etching resistance sufficiently to the chlorine-based gas, it is possible to thin the hard mask film composed of a material containing silicon (Si). An etching time of the fluorine-based dry etching for the hard mask film is shortened when the hard mask film composed of a material containing silicon (Si) is thinned. As a result, the thickness of the resist film required for forming the pattern of the hard mask film composed of a material containing silicon (Si) can also be reduced.

For this reason, by using a hard mask film composed a material containing silicon (Si), it is possible to thin the resist film used for etching of the hard mask film, in particular, the resist film first used for the phase shift mask blank. By thinning the resist film, the height-to-width ratio (aspect ratio) of the resist pattern is reduced. Therefore, in development process for forming a resist pattern, influence of impact of the developing solution or impact of pure water during rinsing is reduced, a good assist pattern can be formed, and it is possible to realize high resolution of a transfer pattern.

In particular, a general method for manufacturing a phase shift mask from a phase shift mask blank in which a phase shift film composed of a material containing silicon (Si), a light-shielding film composed of a material containing chromium (Cr), and a hard mask film composed of a material containing silicon (Si) are formed in this order on a transparent substrate by patterning the phase shift film is as follows. First, a resist film is formed on the hard mask film, and a resist pattern is formed by drawing a pattern onto the resist film by light or an electron beam, and developing. Next, the hard mask film composed of a material containing silicon (Si) is dry-etched with using the resist pattern as an etching mask, and a fluorine-based gas to form a pattern of the hard mask film, then, the resist pattern is removed. Next, the light-shielding film composed of a material containing chromium (Cr) is dry-etched with using the pattern of the hard mask film as an etching mask, and a chlorine-based gas to form a pattern of the light-shielding film. Further, the phase shift film composed of a material containing silicon (Si) is dry-etched with using the pattern of the light-shielding film as an etching mask, and a fluorine-based gas to form a pattern of the phase shift film, and the pattern of the hard mask film is simultaneously removed. Then, the pattern of the light-shielding film is removed by etching using a chlorine-based gas.

However, it is becoming difficult to obtain further high desired pattern resolution, which has been demanded in projection exposure in recent years, even with a phase shift mask. Consequently, in generation of logic 7 nm or later, EUV lithography using, as exposure light, light in extreme ultraviolet range (EUV light) has been utilized.

Light in extreme ultraviolet range is easily absorbed by every material, and transmission type lithography such as conventional photolithography using ArF excimer laser light cannot be applied. Therefore, a reflective optical system is used in EUV lithography (lithography utilizing light in extreme ultraviolet (EUV) range as exposure light). A wavelength of light in extreme ultraviolet range used in EUV lithography is 13 to 14 nm, and the wavelength of conventional ArF excimer laser light is 193 nm. Thus, the wavelength of the light in extreme ultraviolet range is shorter compared with that of the conventional photolithography using ArF excimer laser light, and it is possible to transfer finer patterns formed in a reflective photomask.

A reflective photomask blank used in EUV lithography generally has a structure in which a reflection film that reflects light in extreme ultraviolet range, a protection film for protecting the reflection film, and a light absorbing film that absorbs the light in extreme ultraviolet range are formed in this order on a substrate such as a glass substrate. As the reflection film, a multilayer reflection film in which low refractive index layers and high refractive index layers are alternately laminated that can enhance reflectance when light in the extreme ultraviolet range is irradiated to the surface of the reflection film is used. Generally, for the multilayer reflection film, a molybdenum (Mo) layer is used as the low refractive index layer, and a silicon (Si) layer is used as the high refractive index layer, respectively. A ruthenium (Ru) film is generally used as the protection film. On the other hand, for the light absorbing film, a material having a high absorption coefficient to light in extreme ultraviolet range, in particular, for example, a material containing chromium (Cr) or tantalum (Ta), as a main component, is used. In early generation of EUV lithography, a binary-type reflective photomask in which light is not reflected by the light absorbing film is used.

From a reflective photomask blank, a reflective photomask in which the light absorbing film of the reflective photomask blank has been patterned is manufactured. In particular, a general method for manufacturing a reflective photomask from a reflective photomask blank in which a reflection film that reflects light in extreme ultraviolet range, a protection film for protecting the reflection film, and a light absorbing film that absorbs the light in extreme ultraviolet range are formed in this order on a substrate by patterning the light absorbing film is as follows. First, a resist film is formed on the light absorbing film, and a resist pattern is formed by drawing a pattern onto the resist film by light or an electron beam, and developing. Next, a pattern of the light absorbing film is formed by patterning the light absorbing film with using a resist pattern as an etching mask, then the resist pattern is removed.

**In** the binary-type reflective photomask used for EUV lithography, assist patterns of line patterns and space patterns that assist resolution of main patterns are further finer in accordance with miniaturization of the main patterns, and it is required that a line width of the assist patterns is reduced to about 30 nm, particularly about 25 nm. Thus, a resist film used for the binary-type reflective photomask blank is required to be further thinned compared with the transmissive phase shift mask blank. **In** a reflective photomask, when assist patterns of line patterns and space patterns having a thickness of about 30 nm, particularly about 25 nm is formed, it is required to reduce the thickness of a resist film to not more than 80 nm.

Furthermore, in EUV lithography, to form finer patterns on a wafer, an optical system having a numerical aperture NA of an exposure device that is modified from 0.33 to 0.55 is used. In this case, in a reflective photomask, the assist patterns of line patterns and space patterns that assist resolution of the main patterns are minimized in accordance with minimizing the main patterns, and it is necessary to be minimized a line width of the assist patterns to not more than 20 nm, particularly to about 18 nm. Therefore, in a reflective photomask blank for a reflective photomask used in an exposure device with a numerical aperture NA of 0.55, it is necessary to further thin the resist film.

For example, when a pattern (circuit pattern) of a light absorbing film is formed from the light absorbing film containing tantalum (Ta) as a main component by fluorine-based dry etching with using a resist pattern as an etching mask, fluorine-based dry etching is anisotropic etching dominated by physical components, and an etching rate of the resist pattern is relatively high. Thus, when the resist pattern is too thin, the resist pattern disappears during dry etching of the light absorbing film, resulting in formation of pinhole defects in the light absorbing film, and a reflective photomask that normally functions in EUV lithography cannot be manufactured.

To avoid the generation of the pinhole defects, the resist film is necessary to be formed thick. However, a thick resist film results in a higher height-to-width ratio (aspect ratio) of the resist pattern in forming a finer assist pattern. Thus, in the developing process for forming a resist pattern, the resist pattern collapses by impact of a developing solution or impact of pure water during rinsing. As a result, desired resolution cannot be obtained.

Furthermore, in generation of logic 5 nm or later, a reflective photomask that utilizes a phase shift effect is used to form finer patterns on a wafer in EUV lithography. By using a phase shift-type reflective photomask, higher wafer transfer properties (NILS (Normalized Image Log Slope): contrast of light intensity transferred to the wafer) can be obtained compared with a binary-type reflective photomask, thus, it is possible to form finer patterns on a wafer.

In this regard, in a reflective phase shift photomask, the assist patterns of the line patterns and space patterns, which assist resolution of main patterns, are further finer in accordance with miniaturization of the main patterns. Therefore, compared with the binary-type reflective photomask blank, a reflective phase shift photomask blank requires a further thinner resist film, and an etching mask film (hard mask film) that assists dry etching is required.

For example, WO 2015/098400 A1 (Patent document 1) discloses a reflective mask blank for EUV lithography in which, on a substrate, a multilayer reflective film that reflects EUV light, a Ru-based protection film that protects the multilayer reflection film, a diffusion prevention layer that suppresses mutual diffusion due to thermal diffusion between the protection film and a phase shift film (absorber film), a phase shift film (absorber film) that is composed of a laminated structure of multiple materials, and absorbs and partially reflects the EUV light to shift phase, and an etching mask film are formed in this order. It is described that in a reflective mask obtained from this reflective mask blank, a high contrast can be obtained by setting the phase shift between the light reflected from the phase shift film (absorber film) in a portion having a pattern of the phase shift film (absorber film), and the light reflected from the multilayer reflective film not having a pattern of the phase shift film (absorber film) to 170 to 190 degrees, and that by forming an etching mask film, a resist film can be formed thinner, which is advantageous for miniaturization of patterns.

In addition, WO 2015/098400 A1 (Patent document 1) discloses a method for manufacturing a reflective mask from the reflective mask blank for EUV lithography. In this method, first, a resist film is formed on the etching mask film of the reflective mask blank, a desired pattern is drawn (exposed) on the resist film, and a predetermined resist film pattern is formed by developing and rinsing. Next, an etching mask film pattern is formed by dry etching using a fluorine-based gas with using the resist film pattern as a mask. Next, a chromium-based material layer is dry-etched by a mixed gas of Cl₂ and O₂ with using the resist film pattern and the etching mask film pattern as masks, and then a pattern of the phase shift film (absorber film) is formed by dry etching a tantalum-based material layer with using Cl₂ gas. Finally, the etching mask film pattern is removed by etching using a fluorine-based gas to obtain a reflective mask.

### Citation List

Patent Document 1: WO 2015/098400 A1

### SUMMARY OF THE INVENTION

In WO 2015/098400 A1 (Patent Document 1), the phase shift function is obtained by a laminated structure of multiple materials that is a tantalum-based material layer, and a chromium-based material layer or a ruthenium-based material layer, or a laminated structure of multiple materials that is a tantalum-based material layer, a chromium-based material layer and a ruthenium-based material layer. However, the tantalum-based material layer is etched by oxygen-free chlorine-based gas, and the chromium-based material layer and the ruthenium-based material layer are etched by oxygen-containing chlorine-based gas. Thus, to obtain a pattern of the phase shift film (absorber film), two kinds of dry etchings using different gases are needed. In this case, since etch layer has a different etching rate, it is difficult to control an amount of side etching, and it is difficult to uniformly form a pattern of the laminated structure of multiple materials perpendicular to the substrate. The pattern of the phase shift film (absorber film) with low perpendicularity cannot provide sufficient resolution for finer patterns. Furthermore, when a pattern of the phase shift film is formed from the phase shift film having the laminated structure of multiple materials, it is necessary to apply a complex process that has, for example, gas change, resulting in a decrease in productivity.

On the other hand, as a material for a phase shift film (light absorbing film) in a reflective photomask, a material containing ruthenium (Ru) has advantages in terms of optical properties (light absorbing properties, phase shift properties) for light in extreme ultraviolet range. In the case of a phase shift film (light absorbing film) composed of a material containing ruthenium (Ru), when a material containing ruthenium (Ru), which is effective as a material for protecting a multilayer reflection film, is used as a protection film, the protection film is also etched during etching (patterning) of the phase shift film, and the protection film cannot exert the function as a film for protecting the multilayer reflective film.

The present invention has been made to solve the above problems. An object of the present invention is to provide a reflective photomask blank that can provide a fine assist pattern in a light absorbing film without damaging a multilayer reflection film by etching (patterning) of the light absorbing film, and a method for manufacturing a reflective photomask from the reflective photomask blank.

With respect to a reflective photomask blank using a ruthenium (Ru)-containing material that is advantageous as a material for a light absorbing film having a phase shift function for the light absorbing film, the inventor has made earnestly studies to solve the above problems. As a result, the inventor founds that the above problems can be solved by forming a light absorbing film having a phase shift function that is composed of a single layer containing ruthenium (Ru) as a main component or multiple layers consisting of layers containing ruthenium (Ru) as a main component, forming a hard mask film on the light absorbing film, and further forming a hard mask film consisting of a first layer and a second layer in which the second layer is formed in contact with the light absorbing film and is composed of a material that is resistant to dry etching capable of etching of the light absorbing film.

In one aspect, the invention provides a reflective photomask blank including
a substrate,
a multilayer reflection film that is formed on the substrate and reflects exposure light being light in extreme ultraviolet range,
a protection film that is formed on the multilayer reflection film,
a light absorbing film that is formed on and in contact with the protection film and absorbs the exposure light, and
a hard mask film that is formed on and in contact with the light absorbing film, wherein
   the protection film consists of a first layer that is provided at the substrate-side, and a second layer that is provided at the side remote from the substrate,
   the second layer of the protection film is composed of a material that is resistant to dry etching capable of etching of the light absorbing film,
   the light absorbing film has a phase shift function, and is formed of a single layer or multiple layers, and the single layer and each layer constituting the multiple layers are composed of a material containing ruthenium (Ru) as a main component.
   Preferably, the second layer of the protection film is composed of a material that is resistant to oxygen-containing chlorine-based dry etching, and
   the light absorbing film is composed of a material that can be etched by oxygen-containing chlorine-based dry etching.

Preferably, the second layer of the protection film is composed of a material that is resistant to oxygen-containing chlorine-based dry etching and oxygen-free chlorine-based dry etching,
the light absorbing film is composed of a material that can be etched by oxygen-containing chlorine-based dry etching, and is resistant to oxygen-free chlorine-based dry etching and fluorine-based dry etching, and
the hard mask film is composed of a material that is resistant to oxygen-containing chlorine-based dry etching, and that can be etched by oxygen-free chlorine-based dry etching and fluorine-based dry etching.

Preferably, the first layer of the protection film is composed of a material that is resistant to oxygen-free chlorine-based dry etching.

Preferably, the material containing ruthenium (Ru) as a main component has a ruthenium (Ru) content of not less than 20 at%, and the ruthenium (Ru) has a highest atomic ratio with respect to the total of metal elements and metalloid elements.

Preferably, the light absorbing film has the phase shift function having, with respect to the exposure light, a reflectance of not less than 8% and not more than 28%, and a phase shift of not less than 180 degrees and not more than 240 degrees.

Preferably, the light absorbing film has a thickness of not less than 28 nm and not more than 50 nm.

Preferably, the second layer of the protection film is composed of a material containing at least one selected from the group consisting of tantalum (Ta) and silicon (Si), and oxygen (O).

Preferably, the hard mask film is composed of a material containing silicon (Si) and nitrogen (N).

Preferably, the first layer of the protection film is composed of a material containing ruthenium (Ru).

Preferably, the second layer of the protection film has a thickness of not less than 1 nm and not more than 10 nm.

Preferably, the first layer of the protection film has a thickness of not less than 1 nm and not more than 6 nm.

Preferably, the hard mask film has a thickness of not less than 2 nm and not more than 16 nm.

In the other aspect, the invention provides a method for manufacturing a reflective photomask including the substrate, the multilayer reflection film, the protection film, and a pattern of the light absorbing film from the reflective photomask blank, wherein
the method includes the steps of:
(A) forming a resist film on and in contact with the hard mask film,
(B) patterning the resist film to form a resist pattern,
(C) patterning the hard mask film to form a pattern of the hard mask film by fluorine-based dry etching with using the resist pattern as an etching mask,
(D) removing the resist pattern,
(E) patterning the light absorbing film to form a pattern of the light absorbing film by oxygen-containing chlorine-based dry etching with using the pattern of the hard mask film as an etching mask, and
(F) removing the pattern of the hard mask film by oxygen-free chlorine-based dry etching.

Preferably, the resist film has a thickness of not more than 60 nm, and the pattern of the light absorbing film includes a line pattern having a width of not more than 20 nm.

### ADVANTAGEOUS EFFECTS

According to the reflective photomask blank of the present invention, fine assist patterns can be formed in a light absorbing film having a phase shift function without damaging a multilayer reflection film by etching (patterning) of the light absorbing film, and a reflective photomask that includes a patten of the light absorbing film having a phase shift function in which assist patterns are formed can be manufactured. Particularly, by the reflective photomask blank of the present invention, assist patterns having a line width of not more than 20 nm, particularly not more than 18 nm can be formed in a light absorbing film having a phase shift function by a thin resist film, for example, a resist film having a thickness of not more than 60 nm.

### BRIEF DESCRIPTION OF THE DRAWINGS

FIG. 1 is a cross-sectional view illustrating an example of first embodiment of a reflective photomask blank of the invention.
FIG. 2 is a cross-sectional view illustrating an example of a reflective photomask of the invention.
FIG. 3 is a cross-sectional view illustrating an example of second embodiment of a reflective photomask blank of the invention.
FIGS. 4A to 4F are cross-sectional views for explaining steps of manufacturing a reflective photomask from a reflective photomask blank of the invention.

### FURTHER EXPLANATIONS; OPTIONS AND PREFERENCES

A reflective photomask blank of the invention includes a substrate, a multilayer reflection film that is formed on the substrate, a protection film that is formed on the multilayer reflection film, a light absorbing film that is formed on the protection film, and a hard mask film that is formed on the light absorbing film. In the reflective photomask blank of the invention, the protection film consists of a first layer that is provided at the substrate-side, and a second layer that is provided at the side remote from the substrate.

Structures of a reflective photomask blank and a reflective photomask of the invention are described below with reference to the drawings. In describing the drawings, identical components may be given the same reference symbols and their description may be omitted. In addition, the drawings may be expanded for convenience, and the dimensional ratio of each component may not be the same as actual ratio.

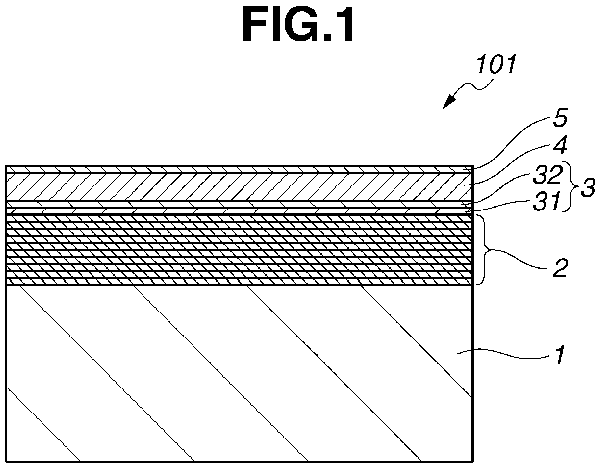

FIG. 1 is a cross-sectional view illustrating an example of first embodiment of a reflective photomask blank of the invention. This reflective photomask blank 101 includes a substrate 1, a multilayer reflection film 2 that is formed on and in contact with the substrate 1, a protection film 3 that is formed on and in contact with the multilayer reflection film 2, a light absorbing film 4 that is formed on and in contact with the protection film 3, and a hard mask film 5 that is formed on and in contact with the light absorbing film 4. The protection film 3 consists of a first layer 31 that is formed in contact with the multilayer reflection film 2, and a second layer 32 that is formed in contact with the light absorbing film 4. In this first embodiment of the reflective photomask blank 101, the multilayer reflection film 2, the first layer 31 of the protection film 3, the second layer 32 of the protection film 3, the light absorbing film 4, and the hard mask film 5 are laminated in this order from the side of the substrate 1.

From the reflective photomask blank of the invention, a reflective photomask including, for example, a substrate, a multilayer reflection film that is formed on the substrate, a protection film that is formed on the multilayer reflection film, and a pattern (circuit pattern or photomask pattern) of a light absorbing film that is formed on the protection film can be obtained.

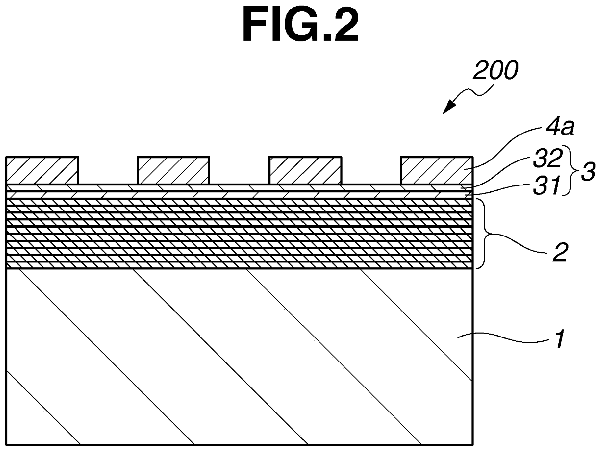

FIG. 2 is a cross-sectional view illustrating an example of a reflective photomask of the invention. This reflective photomask 200 includes a substrate 1, a multilayer reflection film 2 that is formed on and in contact with the substrate 1, a protection film 3 that is formed on and in contact with the multilayer reflection film 2, and a pattern of a light absorbing film 4a that is formed on and in contact with the protection film 3. The protection film 3 consists of a first layer 31 that is formed in contact with the multilayer reflection film 2, and a second layer 32 that is formed in contact with the pattern of the light absorbing film 4a. In this reflective photomask 200, the multilayer reflection film 2, the first layer 31 of the protection film 3, the second layer 32 of the protection film 3, and the pattern of the light absorbing film 4a are laminated in this order from the side of the substrate 1.

In the invention, as oxygen (O)-containing chlorine (Cl)-based dry etching (dry etching using a chlorine (Cl)-based gas containing oxygen (O)), dry etching using a chlorine-based gas containing chlorine gas (Cl₂ gas) with oxygen gas (O₂ gas), in particular, an etching gas consisting of chlorine gas (Cl₂ gas) and oxygen gas (O₂ gas) is exemplified.

In the invention, as oxygen (O)-free chlorine (Cl)-based dry etching (dry etching using a chlorine (Cl)-based gas not containing oxygen (O)), dry etching using a chlorine-based gas containing chlorine gas (Cl₂ gas) and not containing oxygen gas (O₂ gas), in particular, an etching gas consisting of chlorine gas (Cl₂ gas) is exemplified.

In the invention, as fluorine (F)-based dry etching (dry etching using a fluorine (F)-based gas), dry etching using a fluorine-based gas such as carbon tetrafluoride gas (CF₄ gas) and sulfur hexafluoride gas (SF₆ gas), in particular, dry etching using an etching gas containing carbon tetrafluoride gas (CF₄ gas) or sulfur hexafluoride gas (SF₆ gas) and a rare gas such as helium gas (He gas), specifically, an etching gas consisting of carbon tetrafluoride gas (CF₄ gas) or sulfur hexafluoride gas (SF₆ gas) and helium gas (He gas) is exemplified.

In the invention, an etching rate by oxygen-containing chlorine-based dry etching of preferably less than 5 nm/min, more preferably not more than 0.8 nm/min, even more preferably not more than 0.6 nm/min is considered to be resistant to oxygen-containing chlorine-based dry etching. An etching rate by oxygen-containing chlorine-based dry etching of preferably not less than 5 nm/min, more preferably not less than 6 nm/min is considered to be etchable by oxygen-containing chlorine-based dry etching.

In the invention, an etching rate by oxygen-free chlorine-based dry etching of preferably less than 4 nm/min, more preferably not more than 0.8 nm/min, even more preferably not more than 0.6 nm/min is considered to be resistant to oxygen-free chlorine-based dry etching. An etching rate by oxygen-free chlorine-based dry etching of preferably not less than 4 nm/min, more preferably not less than 5 nm/min, even more preferably not less than 6 nm/min is considered to be etchable by oxygen-free chlorine-based dry etching.

In the invention, an etching rate by fluorine-based dry etching of preferably less than 16 nm/min, more preferably not more than 0.8 nm/min, even more preferably not more than 0.6 nm/min is considered to be resistant to fluorine-based dry etching. An etching rate by fluorine-based dry etching of preferably not less than 16 nm/min, more preferably not less than 20 nm/min is considered to be etchable by fluorine-based dry etching.

### [Substrate]

Type or size of the substrate is not particularly limited, and the substrate for the reflective photomask blank and the reflective photomask may be transparent or not transparent with respect to the exposure wavelength. As the substrate, for example, a glass substrate, particularly, a quartz (SiO₂) glass substrate such as a synthetic quartz glass substrate, or a titania-doped quartz glass (SiO₂-TiO₂-based glass) substrate may be used. Further, a suitable substrate is a substrate called a 6025 substrate having sizes of 6 inches square and a thickness of 0.25 inches, which is defined in the SEMI standard. The 6025 substrate is generally represented as a substrate having sizes of 152 mm square and 6.35 mm thick in the SI unit system.

### [Multilayer Reflection Film]

The multilayer reflection film is a film that reflects exposure light being light in extreme ultraviolet range. The multilayer reflection film is preferably formed in contact with the substrate. This light in extreme ultraviolet range is called EUV light, and has a wavelength of 13 to 14 nm. The EUV light is commonly light having a wavelength of about 13.5 nm.

In particular, examples of the material constituting the multilayer reflection film include a material containing molybdenum (Mo) and a material containing silicon (Si). As the multilayer reflection film, a laminated film (Mo/Si laminated film) in which about 20 to 60 layers of molybdenum (Mo) layers and silicon (Si) layers are alternately laminated is generally used. The molybdenum (Mo) layer and the silicon (Si) layer may be a single layer or multiple layers (for example, a layer constituted of two to four sublayers), respectively.

The molybdenum (Mo) layer may be a simple molybdenum (Mo) layer or a molybdenum (Mo) compound layer containing molybdenum (Mo), and at least one light element selected from the group consisting of oxygen (O), nitrogen (N), carbon (C), boron (B) and hydrogen (H). The silicon (Si) layer may be a simple silicon (Si) layer or a silicon (Si) compound layer containing silicon (Si), and at least one light element selected from the group consisting of oxygen (O), nitrogen (N), carbon (C), boron (B) and hydrogen (H).

The multilayer reflection film has a thickness of preferably not less than 200 nm, more preferably not less than 220 nm, and preferably not more than 340 nm, more preferably not more than 280 nm. The molybdenum (Mo) layer has a thickness of preferably not less than 1 nm, more preferably not less than 2 nm, and preferably not more than 5 nm, more preferably not more than 4 nm. The silicon (Si) layer has a thickness of preferably not less than 2 nm, more preferably not less than 3 nm, and preferably not more than 6 nm, more preferably not more than 5 nm. The multilayer reflection film preferably has a reflectance of not less than 65% with respect to light in extreme ultraviolet range (in particular, light having a wavelength of 13.5 nm).

### [Protection Film]

The protection film is a film for protecting the multilayer reflection film. The protection film of the invention consists of a first layer that is provided at the substrate-side, and a second layer that is provided at the side remote from the substrate. The protection film is preferably formed in contact with the multilayer reflection film. The protection film has a function for preventing oxidation of the multilayer reflection film, or a function for protecting the multilayer reflection film in cleaning conducted in process for a reflective photomask, and in correction of the reflective photomask. Further, the protection film has a function for protecting the multilayer reflection film in patterning the light absorbing film by etching. In the invention, the second layer mainly assumes the function for protecting the multilayer reflection film in patterning the light absorbing film by etching. On the other hand, the function for preventing oxidation of the multilayer reflection film, and the function for protecting the multilayer reflection film in cleaning conducted in process for a reflective photomask, and in correction of the reflective photomask may be exerted by both of the first layer and the second layer. Preferably, the first layer mainly assumes these functions, however, not particularly limited thereto.

### [First Layer of Protection Film]

The first layer of the protection film is preferably composed of a material that is resistant to oxygen-free chlorine-based dry etching.

The first layer of the protection film may be composed of a material that is resistant to oxygen-containing chlorine-based dry etching or a material that can be etched by oxygen-containing chlorine-based dry etching. However, the first layer of the protection film is preferably composed of a material that can be etched by oxygen-containing chlorine-based dry etching in the viewpoint of the function for preventing oxidation of the multilayer reflection film, or the function for protecting the multilayer reflection film in cleaning conducted in process for a reflective photomask, and in correction of the reflective photomask.

The first layer of the protection film may be composed of a material that is resistant to fluorine-based dry etching or a material that can be etched by fluorine-based dry etching. However, the first layer of the protection film is preferably composed of a material that can be etched by fluorine-based dry etching in the viewpoint of the function for preventing oxidation of the multilayer reflection film, or the function for protecting the multilayer reflection film in cleaning conducted in process for a reflective photomask, and in correction of the reflective photomask.

The first layer of the protection film is preferably composed of a material that is resistant to a cleaning liquid containing sulfuric acid or a cleaning liquid containing alkali, for example, a sulfuric acid-hydrogen peroxide mixture (SPM).

The first layer of the protection film may be a single layer or multiple layers (for example, a layer constituted of two to four sublayers). The single layer and each layer constituting the multiple layers may have gradient composition.

The first layer of the protection film is preferably composed of a material containing ruthenium (Ru). The material constituting the first layer may be simple ruthenium (Ru), and may be a ruthenium compound added with at least one additive element selected from the group consisting of molybdenum (Mo), niobium (Nb), zirconium (Zr), yttrium (Y), boron (B), titanium (Ti) and lanthanum (La) to enhance resistance to oxygen-free chlorine-based dry etching, or resistance to a cleaning liquid containing sulfuric acid or a cleaning liquid containing alkali. Particularly, the ruthenium compound preferably consists of ruthenium (Ru), and at least one additive element selected from the group consisting of molybdenum (Mo), niobium (Nb), zirconium (Zr), yttrium (Y), boron (B), titanium (Ti) and lanthanum (La).

Reflected exposure light from the multilayer reflection film can be effectively utilized by a first layer of the protection film having a thinner thickness, and productivity in exposure using a reflective photomask is improved. Further, when the first layer of the protection film is too thin, the protection film may insufficiently exert a function as the protection film. Therefore, the first layer of the protection film has a thickness of preferably not more than 6 nm, more preferably not more than 4 nm, and preferably not less than 1 nm.

### [Second Layer of Protection Film]

The second layer of the protection film assumes the function for protecting the multilayer reflection film (preventing etching to the multilayer reflection film) in patterning the light absorbing film by etching. The second layer of the protection film is composed of a material that is resistant to dry etching capable of etching of the light absorbing film. In the reflective photomask blank of the invention, since the protection film has the second layer, the protection film is not significantly damaged in etching for patterning the light absorbing film. Therefore, long-time over-etching can be applied in the etching for patterning the light absorbing film.

The second layer of the protection film is preferably composed of a material that is resistant to oxygen-containing chlorine-based dry etching.

The second layer of the protection film may be composed of a material that is resistant to oxygen-free chlorine-based dry etching or a material that can be etched by oxygen-free chlorine-based dry etching. However, the second layer of the protection film is preferably composed of a material that is resistant to oxygen-free chlorine-based dry etching to protect the multilayer reflection film (to prevent etching to the multilayer reflection film) in removing the hard mask film by oxygen-free chlorine-based dry etching.

The second layer of the protection film may be composed of a material that is resistant to fluorine-based dry etching or a material that can be etched by fluorine-based dry etching. However, the second layer of the protection film is preferably composed of a material that can be etched by fluorine-based dry etching in the viewpoint of the function for preventing oxidation of the multilayer reflection film, or the function for protecting the multilayer reflection film in cleaning conducted in process for a reflective photomask, and in correction of the reflective photomask.

The second layer of the protection film may be a single layer or multiple layers (for example, a layer constituted of two to four sublayers). The single layer and each layer constituting the multiple layers may have gradient composition.

The second layer of the protection film is preferably composed of a material containing at least one selected from the group consisting of tantalum (Ta) and silicon (Si). The material constituting the second layer of the protection film is preferably free of ruthenium (Ru). The material constituting the second layer of the protection film may be a material consisting of at least one selected from the group consisting of tantalum (Ta) and silicon (Si), however, is preferably a material containing another element, for example, at least one light element selected from the group consisting of oxygen (O), nitrogen (N) and carbon (C), with at least one selected from the group consisting of tantalum (Ta) and silicon (Si). In particular, the material is preferably a material containing at least one selected from the group consisting of tantalum (Ta) and silicon (Si), and oxygen (O), more preferably a material consisting of at least one selected from the group consisting of tantalum (Ta) and silicon (Si), and oxygen (O) (silicon oxide (SiO), tantalum oxide (TaO), tantalum silicon oxide (TaSiO)). In the case of the material containing oxygen (O), the material has an oxygen (O) content of preferably not less than 20 at%, more preferably not less than 30 at%, however not particularly limited thereto.

In the case that the second layer of the protection film contains another element except for tantalum (Ta) and silicon (Si), the second layer of the protection film has a total content of tantalum (Ta) and silicon (Si) of less than 100 at%, and the second layer of the protection film has a total content of tantalum (Ta) and silicon (Si) of preferably not more than 80 at%, more preferably not more than 70 at%, even more preferably not more than 60 at%. In the case of a lower total content of tantalum (Ta) and silicon (Si), resistance to oxygen-free chlorine-based dry etching is improved, however, resistance to oxygen-containing chlorine-based dry etching may be deteriorated. Therefore, the total content of tantalum (Ta) and silicon (Si) is preferably not less than 20 at%, more preferably not less than 30 at%.

In the case that the second layer of the protection film is composed of tantalum oxide (TaO), the second layer of the protection film has a tantalum (Ta) content of preferably not more than 80 at%, more preferably not more than 70 at%, even more preferably not more than 60 at%, and preferably not less than 20 at%, more preferably not less than 30 at %. In this case, the oxygen (O) content is the balance relative to the tantalum (Ta) content.

In the case that the second layer of the protection film is composed of silicon oxide (SiO), the second layer of the protection film has a silicon (Si) content of preferably not more than 80 at%, more preferably not more than 70 at%, even more preferably not more than 60 at%, and preferably not less than 20 at%, more preferably not less than 30 at%. In this case, the oxygen (O) content is the balance relative to the silicon (Si) content.

Reflected exposure light from the multilayer reflection film can be effectively utilized by a second layer of the protection film having a thinner thickness, and productivity in exposure using a reflective photomask is improved. Further, when the second layer of the protection film is too thin, the protection film may insufficiently exert a function as the protection film. Therefore, the second layer of the protection film has a thickness of preferably not more than 10 nm, more preferably not more than 4 nm, even more preferably not more than 2 nm, and preferably not less than 1 nm, more preferably not less than 1.5 nm.

### [Light absorbing Film]

The light absorbing film is a film that absorbs exposure light being light in extreme ultraviolet range. The light absorbing film is preferably formed in contact with the protection film (the second layer of the protection film).

Since the second layer of the protection film is composed of a material that is resistant to dry etching capable of etching of the light absorbing film, etching of the light absorbing film is etching to which the second layer of the protection film has resistance, and a material for the light absorbing film is selected such that the second layer of the protection film is resistant to the etching of the light absorbing film. Therefore, the light absorbing film is composed of a material having different etching characteristics to those of the second layer of the protection film. The light absorbing film is preferably composed of a material that can be etched by oxygen-containing chlorine-based dry etching.

The light absorbing film may be composed of a material that is resistant to oxygen-free chlorine-based dry etching or a material that can be etched by oxygen-free chlorine-based dry etching. However, the light absorbing is preferably composed of a material that is resistant to oxygen-free chlorine-based dry etching so as not to be etched in removing the hard mask film by oxygen-free chlorine-based dry etching.

The light absorbing film may be composed of a material that is resistant to fluorine-based dry etching or a material that can be etched by fluorine-based dry etching. However, the light absorbing film is preferably composed of a material that is resistant to fluorine-based dry etching so as not to be etched in patterning the hard mask film by fluorine-based dry etching.

In the invention, the light absorbing film is composed of a material containing ruthenium (Ru), preferably a material containing ruthenium (Ru) as a main component. The light absorbing film is formed by a single layer or multiple layers (for example, two to five layers), and the single layer and each layer constituting the multiple layers are more preferably composed of a material containing ruthenium (Ru) as a main component. By the light absorbing film that is composed of a unitary material, it is possible to form a pattern of the light absorbing film having a good cross section shape. In this regard, preferably, the light absorbing film is constituted of a single layer. In the case that the light absorbing film is constituted of multiple layers, it is preferable that the constituent elements in all layers are the same. In this case, each of the layers may be formed so as to have a different ratio of the constituent elements. The single layer and each layer constituting the multiple layers may have gradient composition.

The material containing ruthenium (Ru) as a main component is a material that contains ruthenium (Ru) in the most amount in terms of atomic ratio to the total amount of metal elements and metalloid elements contained in the material containing ruthenium (Ru) as a main component. The ratio of the amount of ruthenium (Ru) to the total amount of metal elements and metalloid elements contained in the material containing ruthenium (Ru) as a main component is preferably not less than 40 at%, more preferably not less than 50 at%, even more preferably not less than 52 at%. The material containing ruthenium (Ru) has a ruthenium (Ru) content of preferably not less than 20 at%, more preferably not less than 50 at%, even more preferably not less than 52 at%.

The material containing ruthenium (Ru) as a main component may contain at least one element selected from the group consisting of metal elements and metalloid elements other than ruthenium (Ru), and may contain at least one element selected from the group consisting of niobium (Nb), molybdenum (Mo) and tantalum (Ta) as the metal elements and the metalloid elements other than ruthenium (Ru). Further, the material containing ruthenium (Ru) as a main component may contain at least one light element selected from the group consisting of oxygen (O), nitrogen (N) and carbon (C) as an element other than the metal elements and the metalloid elements.

Examples of the materials containing ruthenium (Ru) as a main component include simple ruthenium (Ru), and a ruthenium compound containing ruthenium (Ru) and at least one selected from the group consisting of niobium (Nb), molybdenum (Mo), tantalum (Ta), oxygen (O) and nitrogen (N). In particular, simple ruthenium (Ru), ruthenium oxide (RuO) consisting of ruthenium (Ru) and oxygen (O), ruthenium oxynitride (RuON) consisting of ruthenium (Ru), oxygen (O) and nitrogen (N), ruthenium tantalum nitride (RuTaN) consisting of ruthenium (Ru), tantalum (Ta) and nitrogen (N), and ruthenium molybdenum nitride (RuMoN) consisting of ruthenium (Ru), molybdenum (Mo) and nitrogen (N) are exemplified.

In the case that the material containing ruthenium (Ru) as a main component contains ruthenium (Ru) and oxygen (O), particularly, is ruthenium oxide (RuO), the material has a ruthenium (Ru) content of preferably not less than 60 at%, more preferably not less than 65 at%, and preferably not more than 90 at%, more preferably not more than 85 at%. On the other hand, the material has an oxygen (O) content of preferably not less than 10 at%, more preferably not less than 15 at%, and preferably not more than 40 at%, more preferably not more than 35 at%.

In the case that the material containing ruthenium (Ru) as a main component contains ruthenium (Ru), oxygen (O) and nitrogen (N), particularly, is ruthenium oxynitride (RuON), the material has a ruthenium (Ru) content of preferably not less than 80 at%, more preferably not less than 85 at%, and preferably not more than 96 at%, more preferably not more than 90 at%. Further, the material has an oxygen (O) content of preferably not less than 2 at%, more preferably not less than 4 at%, and preferably not more than 10 at%, more preferably not more than 8 at%. On the other hand, the material has a nitrogen (N) content of preferably not less than 2 at%, more preferably not less than 4 at%, and preferably not more than 10 at%, more preferably not more than 8 at%.

In the case that the material containing ruthenium (Ru) as a main component contains ruthenium (Ru), tantalum (Ta) and nitrogen (N), particularly, is ruthenium tantalum nitride (RuTaN), the material has a ruthenium (Ru) content of preferably not less than 40 at%, more preferably not less than 50 at%, and preferably not more than 80 at%, more preferably not more than 60 at%. Further, the material has a tantalum (Ta) content of preferably not less than 8 at%, more preferably not less than 10 at%, and preferably not more than 30 at%, more preferably not more than 20 at%. On the other hand, the material has a nitrogen (N) content of preferably not less than 2 at%, more preferably not less than 4 at%, even more preferably not less than 10 at%, and preferably not more than 50 at%, more preferably not more than 40 at%.

In the case that the material containing ruthenium (Ru) as a main component contains ruthenium (Ru), molybdenum (Mo) and nitrogen (N), particularly, is ruthenium molybdenum nitride (RuMoN), the material has a ruthenium (Ru) content of preferably not less than 30 at%, more preferably not less than 40 at%, and preferably not more than 80 at%, more preferably not more than 60 at%. Further, the material has a molybdenum (Mo) content of preferably not less than 5 at%, more preferably not less than 10 at%, and preferably not more than 50 at%, more preferably not more than 40 at%. On the other hand, the material has a nitrogen (N) content of preferably not less than 10 at%, more preferably not less than 20 at%, and preferably not more than 50 at%, more preferably not more than 30 at%.

Ruthenium niobium (RuNb) consisting of ruthenium (Ru) and niobium (Nb), ruthenium niobium oxide (RuNbO) consisting of ruthenium (Ru), niobium (Nb) and oxygen (O), and ruthenium niobium oxynitride (RuNbON) consisting of ruthenium (Ru), niobium (Nb), oxygen (O) and nitrogen (N) are also suitable as the material containing ruthenium (Ru) as a main component.

Ruthenium oxide (RuO), ruthenium oxynitride (RuON), ruthenium tantalum nitride (RuTaN), ruthenium molybdenum nitride (RuMoN), ruthenium niobium (RuNb), ruthenium niobium oxide (RuNbO), and ruthenium niobium oxynitride (RuNbON), which are specifically exampled as the material containing ruthenium (Ru) as a main component, are particularly suitable as a material that can be etched by oxygen-containing chlorine-based dry etching, and is resistant to oxygen-free chlorine-based dry etching and fluorine-based dry etching.

In the invention, the light absorbing film is a film having a phase shift function, i.e., a phase shift film. The reflective photomask blank and reflective photomask of the invention can be referred to as a reflective photomask blank having a phase shift function (a reflective phase shift photomask blank) and a reflective photomask having a phase shift function (a reflective phase shift photomask), respectively. By the light absorbing film having a phase shift function, the wafer transfer characteristics (NILS: Normalized Image Log-Slope) can be improved.

The light absorbing film of the invention is formed on the second layer of the protection film, and the second layer of the protection film is composed of a material that is resistant to dry etching capable of etching of the light absorbing film. The second layer of the protection film is formed between the multilayer reflection film and the light absorbing film, and the second layer of the protection film may be left in the reflective photomask unlike a buffer layer which is removed during a manufacturing process of the reflective photomask after patterning the light absorbing film. Therefore, a predetermined phase shift function (reflectance, phase shift) may be exerted by the light absorbing film alone.

The light absorbing film having a phase shift function (phase shift film) has a reflectance of preferably not less than 8%, more preferably not less than 14%, and preferably not more than 28%, more preferably not more than 18%, with respect to exposure light being light in extreme ultraviolet range. This reflectance is a relative reflectance to the multilayer reflection film, in particular, a ratio of a reflectance of the light reflected from the light absorbing film that is formed via the multilayer reflection film and the protection film on the substrate to a reflectance of the light reflected from the multilayer reflection film and the protection film that are formed on the substrate.

The light absorbing film having a phase shift function (phase shift film) has a phase shift of preferably not less than 180 degrees, more preferably not less than 210 degrees, and preferably not more than 240 degrees, more preferably not more than 220 degrees with respect to exposure light being light in extreme ultraviolet range. This phase shift is a relative phase shift to the multilayer reflection film, in particular, a difference between a phase of the light reflected from the multilayer reflection film and the protection film that are formed on the substrate and a phase of the light reflected from the light absorbing film that is formed via the multilayer reflection film and the protection film on the substrate.

In the invention, the light absorbing film has a thickness of preferably not less than 10 nm, more preferably not less than 15 nm, even more preferably not less than 20 nm, further preferably not less than 28 nm, most preferably not less than 35 nm, and preferably not more than 100 nm, more preferably not more than 80 nm, even more preferably not more than 60 nm, further preferably not more than 50 nm, most preferably not more than 48 nm.

### [Hard Mask Film]

The hard mask film is a film that functions as an etching mask in etching for patterning the light absorbing film by dry etching. The hard mask film is preferably formed in contact with the light absorbing film. The hard mask film is composed of a material having different etching characteristics to those of the light absorbing film. In particular, the hard mask film is preferably composed of a material that is resistant to oxygen-containing chlorine-based dry etching.

The hard mask film may be composed of a material that is resistant to oxygen-free chlorine-based dry etching or a material that can be etched by oxygen-free chlorine-based dry etching. However, the hard mask film is preferably composed of a material that can be etched by oxygen-free chlorine-based dry etching so as to form the hard mask film that can be removed by oxygen-free chlorine-based dry etching.

The hard mask film may be composed of a material that is resistant to fluorine-based dry etching or a material that can be etched by fluorine-based dry etching. However, the hard mask film is preferably composed of a material that can be etched by fluorine-based dry etching to form the hard mask film that can etched by fluorine-based dry etching in patterning the hard mask film.

The hard mask film may be a single layer or multiple layers (for example, a film constituted of two to five layers). The single layer and each layer constituting the multiple layers may have gradient composition.

As a material constituting the hard mask film, a material containing silicon (Si) is preferable. The material constituting the hard mask film is preferably a material free of ruthenium (Ru). The material constituting the hard mask film may be a material consisting of silicon (Si), however, is preferably a material containing another element, for example, at least one light element selected from the group consisting of oxygen (O), nitrogen (N) and carbon (C) with silicon (Si).

In the case that the material constituting the hard mask film contains the other element other than silicon (Si), the material has a silicon (Si) content of less than 100 at%, and preferably not more than 90 at%, more preferably not more than 80 at%. Since the material having a low silicon (Si) content has high resistance to oxygen-free chlorine-based dry etching, the material has a silicon (Si) content of preferably not less than 40 at%, more preferably not less than 50 at%. As the material constituting the hard mask film, particularly, a material containing silicon (Si) and nitrogen (N), especially, a material consisting of silicon (Si) and nitrogen (N) (silicon nitride (SiN)) is preferable. In the case that the material constituting the hard mask film contains nitrogen (N), the material has a nitrogen (N) content of preferably not less than 10 at%, more preferably not less than 20 at%.

In the case that the material constituting the hard mask film is silicon nitride (SiN), the material has a silicon (Si) content of preferably not less than 40 at%, more preferably not less than 50 at%, and preferably not more than 90 at%, more preferably not more than 80 at%. In this case, the nitrogen (N) content is the balance relative to the silicon (Si) content.

When the hard mask film has a lower silicon (Si) content, an etching rate by a fluorine-based gas in fluorine-based dry etching is high, and a thinner resist film can be used in patterning the hard mask film. However, the hard mask film having a low silicon (Si) content has a small surface roughness, and adhesion between the hard mask film and the resist film is low, thus, resolution of the resist pattern is deteriorated. On the other hand, when the hard mask film has a higher silicon (Si) content, since an etching rate by a fluorine-based gas in fluorine-based dry etching is low, and a thinner resist film cannot be used. However, the hard mask film having a high silicon (Si) content has a larger surface roughness, and adhesion between the hard mask film and the resist film is high, thus, resolution of the resist pattern is improved.

Therefore, by decreasing the silicon (Si) content at the substrate-side of the hard mask film and increasing the silicon (Si) content at the side remote from the substrate, a film having high adhesion to the resist film and a high etching rate can be provided. From this viewpoint, it is also preferable that the hard mask film has a high light element (for example, nitrogen (N)) content at the substrate-side and a low light element (for example, nitrogen (N)) content at the side remote from the substrate.

The hard mask film is usually patterned with using a resist pattern as an etching mask, and an etching time is shortened by a thinner hard mask film. When the hard mask film is too thin, a function as an etching mask in etching the light absorbing film may be lost, and sensitivity of the defect inspection of the hard mask film may be reduced. Therefore, the hard mask film has a thickness of preferably not more than 16 nm, more preferably not more than 10 nm, and preferably not less than 2 nm, more preferably not less than 4 nm.

### [Conducting Film]

The reflective photomask is usually secured by electrostatic chucking on a mask stage of an exposure apparatus. Therefore, the reflective photomask blank and the reflective photomask of the invention may include a conducting film (a back-surface film) to secure the reflective photomask by the electrostatic chucking on the back-surface oppose to the front-surface on which films such as the multilayer reflection film and others are formed. The conducting film is preferably formed in contact with the substrate.

The conducting film preferably has a sheet resistance of not more than 100 Ω/square. The conducting film is not particularly limited by a material. Examples of materials of the conducting film include, for example, a material containing tantalum (Ta) or chromium (Cr). The material containing tantalum (Ta) or chromium (Cr) may contain oxygen (O), nitrogen (N), carbon (C), boron (B) or others. The conducting film may have a thickness not particularly limited as long as it functions for electrostatic chucking use. Normally, the thickness is about 20 to 300 nm.

### [Resist Film]

The reflective photomask blank of the invention may further include a resist film. Further, when the reflective photomask is manufactured from the reflective photomask blank not including a resist film, a resist film is formed on the reflective photomask blank, generally, on the hard mask film. The resist is preferably formed in contact with the hard mask film.

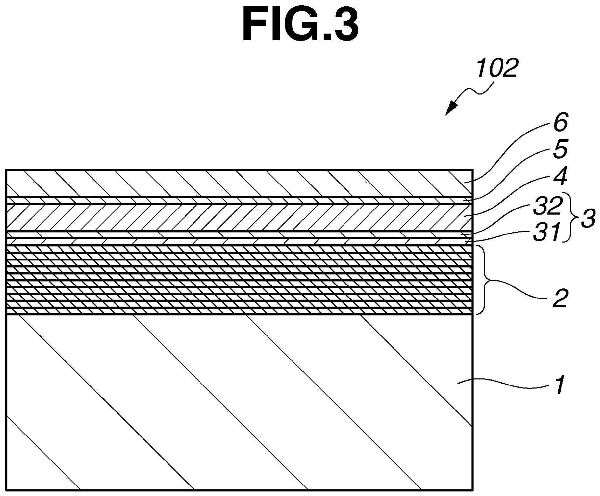

FIG. 3 is a cross-sectional view illustrating an example of second embodiment of a reflective photomask blank of the invention. This reflective photomask blank 102 includes a substrate 1, a multilayer reflection film 2 that is formed on and in contact with the substrate 1, a protection film 3 that is formed on and in contact with the multilayer reflection film 2, a light absorbing film 4 that is formed on and in contact with the protection film 3, a hard mask film 5 that is formed on and in contact with the light absorbing film 4, and a resist film 6 that is formed on and in contact with the hard mask film 5. The protection film 3 consists of a first layer 31 that is formed in contact with the multilayer reflection film 2, and a second layer 32 that is formed in contact with the light absorbing film 4. In this second embodiment of the reflective photomask blank 102, the multilayer reflection film 2, the first layer 31 of the protection film 3, the second layer 32 of the protection film 3, the light absorbing film 4, the hard mask film 5 and the resist film 6 are laminated in this order from the side of the substrate 1.

In the invention, the resist film may be an electron beam resist that is drawn with an electron beam or a photoresist that is drawn with light, and a chemically amplified resist is preferable. The chemically amplified resist may be a positive type or a negative type. Examples of the chemically amplified resists include a resist containing a base resin such as a hydroxystyrene-based resin or a (meth)acrylic acid-based resin, and an acid generator, and optionally containing a cross-linking agent, a quencher, a surfactant, or other components.

### [Film Forming Method]

In the invention, the multilayer reflection film, the protection film (the first layer and the second layer), the light absorbing film, the hard mask film and the conducting film are preferably formed by a sputtering method that has good controllability and can be easy to form a film having predetermined characteristics, however, not particularly limited thereto. As the sputtering method, DC sputtering, RF sputtering can be applied, however, not particularly limited.

When a laminated film of molybdenum (Mo) layers and silicon (Si) layers, as the multilayer reflection film, is formed, a molybdenum (Mo) target and a silicon (Si) target can be used as sputtering targets.

When the first layer of the protection film is composed of a material containing ruthenium (Ru), a ruthenium (Ru) target, and an optional target appropriately selected from the group consisting of a molybdenum (Mo) target, a niobium (Nb) target, a zirconium (Zr) target, an yttrium (Y) target, a titanium (Ti) target, and a lanthanum (La) target can be used, as a sputtering target.

When the second layer of the protection film is composed of a material containing tantalum (Ta), a tantalum (Ta) target can be used as a sputtering target. When the second layer of the protection film is composed of a material containing silicon (Si), a silicon (Si) target can be used as a sputtering target.

When the light absorbing film is composed of a material containing ruthenium (Ru), a ruthenium (Ru) target, and an optional target appropriately selected from the group consisting of a niobium (Nb) target, a molybdenum (Mo) target, and a tantalum (Ta) target can be used, as a sputtering target.

When the hard mask film is composed of a material containing silicon (Si), a silicon (Si) target can be used as a sputtering target.

When the conducting film is composed of a material containing tantalum (Ta) or chromium (Cr), a tantalum (Ta) target or a chromium (Cr) target can be used as a sputtering target.

A power to be supplied to the sputtering target may be appropriately set depending on the size of the sputtering target, cooling efficiency, controllability of film formation. The power is normally 50 to 3000 W/cm² as a power per area of the sputtering surface of the sputtering target. As a sputtering gas, a rare gas such as helium gas (He gas), neon gas (Ne gas) and argon gas (Ar gas) may be used. When each film (each layer constituting the film, or each sublayer constituting the layer) that contains only the element constituting the target is formed, only the rare gas may be used as the sputtering gas.

When each film (each layer constituting the film, or each sublayer constituting the layer) is composed of a material containing at least one light element selected from the group consisting of oxygen (O), nitrogen (N), carbon (C) and hydrogen (H), the sputtering is preferably reactive sputtering. In the reactive sputtering, a rare gas such as helium gas (He gas), neon gas (Ne gas) and argon gas (Ar gas), and a reactive gas are used as sputtering gases.

As the reactive gas, for example, oxygen gas (O₂ gas) can be used in the case of forming by a material containing oxygen (O), nitrogen gas (N₂ gas) can be used in the case of forming by a material containing nitrogen (N), a nitrogen oxide gas such as nitrogen monoxide gas (NO gas), nitrogen dioxide gas (NO₂ gas) and nitrous oxide gas (N₂O gas) can be used in the case of forming by a material containing oxygen (O) and nitrogen (N), a carbon oxide gas such as carbon monoxide gas (CO gas) and carbon dioxide gas (CO₂) can be used in the case of forming by a material containing carbon (C) and oxygen (O), and methane gas (CH₄ gas) can be used in the case of forming by a material containing carbon (C) and hydrogen (H).

Further, a target added with boron (B) can be used in the case of forming by a material containing boron (B).

A pressure in forming each film (each layer constituting the film, or each sublayer constituting the layer) may be appropriately set in consideration of film stress, chemical resistance, cleaning resistance. Particularly, chemical resistance is improved by setting the pressure at preferably not less than 0.01 Pa, more preferably not less than 0.03 Pa, and preferably not more than 1 Pa, more preferably not more than 0.3 Pa. Further, a flow rate of each gas may be appropriately set so as to obtain a desired composition, and may be set normally 0.1 to 100 sccm.

In manufacturing process of the reflective photomask blank, the substrate or the substrate and the film formed on the substrate may be heat-treated before forming the resist film. As a heat treatment method, an infrared heating, a resistance heating or others can be applied, and conditions of the treatment are not particularly limited. The heat treatment may be performed, for example, under atmosphere of a gas containing oxygen (O). The gas containing oxygen (O) has a concentration of, for example, 1 to 100 vol% in the case of oxygen gas (O₂ gas), however not particularly limited thereto. The heat treatment is performed at a temperature of preferably not less than 200 °C, more preferably not less than 400 °C.

In manufacturing process of the reflective photomask blank, before forming the resist film, the film formed on the substrate, particularly the hard mask film may be subjected to ozone treatment, or plasma treatment. Each treatment may be carried out to increase oxygen concentration in the surface portion of the film. In this case, the conditions of the treatment may be appropriately adjusted so as to obtain a predetermined oxygen concentration. In addition, when the film is formed by sputtering, the oxygen concentration in the surface portion of the film can be increased also by adjusting a ratio of the rare gas and the gas containing oxygen (oxidizing gas) such as oxygen gas (O₂ gas), carbon monoxide gas (CO gas), and carbon dioxide gas (CO₂ gas) in the sputtering gas.

Further, in manufacturing process of the reflective photomask blank, before forming the resist film, a cleaning treatment may be performed to remove defects which present on the surface of the substrate or the film formed on the substrate. The cleaning can be performed with using either or both of ultrapure water and a functional water, which is ultrapure water containing ozone gas (O₃ gas), hydrogen gas (H₂ gas), or others. Further, the cleaning may be performed by ultrapure water containing a surfactant, followed by cleaning with either or both of ultrapure water and the functional water. The cleaning may be performed while irradiating with ultrasonic wave, if necessary, and may also be combined with UV light irradiation.

A method of forming the resist film (applying the resist) is not particularly limited, and a known method such as spin coating may be applied.

### [Manufacturing of Reflective Photomask]

A reflective photomask that includes the substrate, the multilayer reflection film, the protection film and a pattern of the light absorbing film can be manufactured from the reflective photomask blank of the invention. The protection film, particularly, the second layer of the protection film differs from a buffer layer that is removed in the process for manufacturing the reflective photomask, and may be left in the reflective photomask. Thus, a step for removing the second layer of the protection film may be unnecessary, and the step for removing the second layer of the protection film is preferably not included.

Ideally, the protection film included in the reflective photomask blank is entirely (entirely in the thickness direction) remained as the protection film included in the reflective photomask. Therefore, it is preferable to manufacture the reflective photomask of the invention so that the protection film (the first layer and the second layer) is entirely (entirely in the thickness direction) remained. However, during the manufacturing process of the reflective photomask, particularly during patterning of the light absorbing film or removing of the pattern of the hard mask film, the exposed protection film is exposed to etching. Thus, the reflective photomask of the invention may be manufactured so that at least a part of the first layer (a part in the thickness direction), preferably the entire of the first layer of the protection film (the entire in the thickness direction) and a part of the second layer (a part in the thickness direction) are remained in the protection film.

In manufacturing the reflective photomask, a resist film is formed on the hard mask film when a resist film is not formed in the reflective photomask blank. Then, the reflective photomask can be manufactured by patterning or removing each of the films by applying dry etching appropriately selected from the group consisting of oxygen-containing chlorine-based dry etching, oxygen-free chlorine-based dry etching, fluorine-based dry etching and others, depending on the etching characteristics of the material constituting each film with using, as an etching mask, a resist pattern obtained by patterning the resist film or a pattern of the film obtained by patterning the film such as the hard mask film. In manufacturing the reflective photomask, the resist pattern can be removed with a sulfuric acid-hydrogen peroxide mixture (SPM).

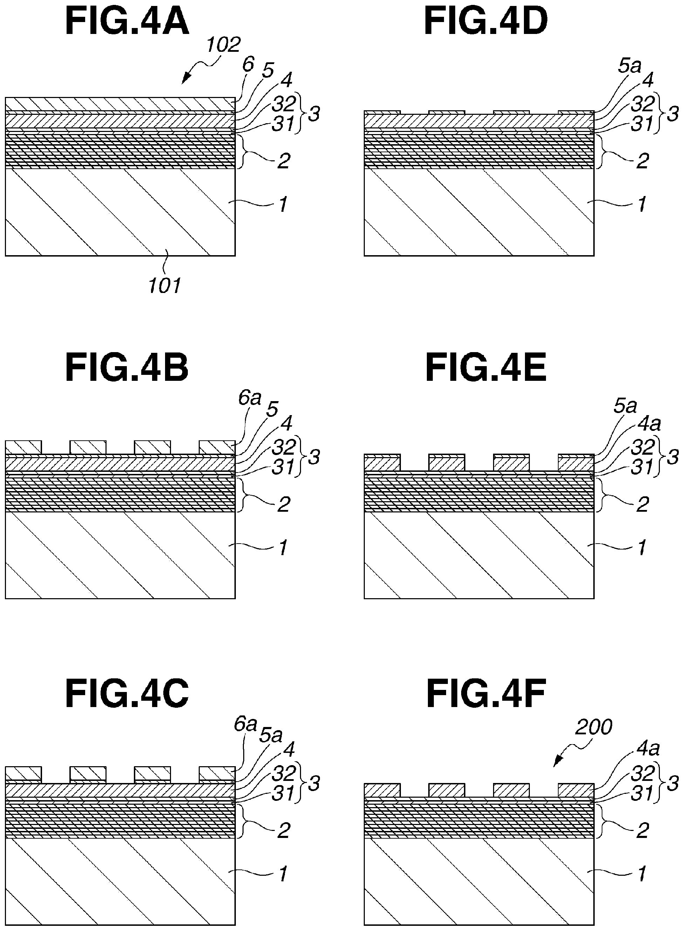

Next, an example of a method for manufacturing a reflective photomask from a reflective photomask blank of the first embodiment or the second embodiment of the invention will be concretely described with reference to the drawings. FIGS. 4A to 4G are cross-sectional views for explaining steps of manufacturing a reflective photomask from a reflective photomask blank of the invention.

First, as described in FIG. 4A, a resist film 6 is formed in contact with the hard mask film 5 of a reflective photomask blank 101 of the first embodiment, or a reflective photomask blank 102 of the second embodiment is prepared (Step (A)).

Next, as described in FIG. 4B, the resist film 6 is patterned to form a resist pattern 6a (Step (B)).

Next, as described in FIG. 4C, the hard mask film 5 is patterned by fluorine-based dry etching with using the resist pattern 6a as an etching mask to form a pattern of the hard mask film 5a (Step (C)).

Next, as described in FIG. 4D, the resist pattern 6a is removed (Step (D)).

Next, as described in FIG. 4E, a light absorbing film 4 is patterned by oxygen-containing chlorine-based dry etching with using the pattern of the hard mask film 5a as an etching mask to form a pattern of the light absorbing film 4a (Step (E)).

Next, as described in FIG. 4F, the pattern of the hard mask film 5a is removed by oxygen-free chlorine-based dry etching (Step (F)).

This method is suitable for manufacturing a reflective photomask from a reflective photomask blank in which the second layer of the protection film is composed of a material that is resistant to oxygen-containing chlorine-based dry etching and oxygen-free chlorine-based dry etching, the light absorbing film is composed of a material that can be etched by oxygen-containing chlorine-based dry etching, and is resistant to oxygen-free chlorine-based dry etching and fluorine-based dry etching, and the hard mask film is composed of a material that is resistant to oxygen-containing chlorine-based dry etching, and can be etched by oxygen-free chlorine-based dry etching and fluorine-based dry etching.

Further, this method is suitable for manufacturing a reflective photomask from a reflective photomask blank in which the second layer of the protection film is composed of a material that contains at least one selected from the group consisting of tantalum (Ta) and silicon (Si), and oxygen (O), the light absorbing film is composed of a material that contains ruthenium (Ru) as a main component, and the hard mask film is composed of a material that contains silicon (Si) and nitrogen (N).

In the invention, the resist film (the resist film for forming on the reflective photomask blank of the first embodiment, and the resist film formed in the reflective photomask blank of the second embodiment) has a thickness of preferably not more than 80 nm, more preferably not more than 70 nm, in the viewpoint of reducing a ratio of height to width (an aspect ratio) of the resist pattern for forming fine assist patterns in development step to form the resist pattern (in the viewpoint of forming the resist pattern so as not to collapse by impact of a developing solution or impact of pure water during rinsing).

From the reflective photomask blank of the invention, a good fine pattern having a line width of not more than 25 nm (for example, 16 to 25 nm), particularly not more than 20 nm (for example, 16 to 20 nm), especially not more than 18 nm (for example, 16 to 18 nm) can be formed in the light absorbing film having a phase shift function by reducing a ratio of height to width (an aspect ratio) of the resist pattern with a thin resist film. Further, a pattern with a highly controlled shape (particularly in cross section of the pattern) can be formed. In the invention, a lower limit of a width of a line pattern such as an assist pattern that can be formed in a pattern of a light absorbing film of a reflective photomask is usually not less than 10 nm, however, not particularly limited thereto.

The thickness of the resist film is further preferably not more than 60 nm in the viewpoint of forming a good line pattern such as an assist pattern having a line width of not more than 25 nm (25 nm, or less than 25 nm), particularly not more than 20 nm (20 nm, or less than 20 nm), especially not more than 18 nm (18 nm, or less than 18 nm). The resist film may have a lower limit in the thickness that can maintain a resist pattern having a predetermined thickness, for example, a thickness of preferably not less than 10 nm, more preferably not less than 15 nm, after etching, and a thickness at which the resist film can be formed with a stable thickness. The thickness of the resist film is preferably not less than 15 nm, more preferably not less than 20 nm, even more preferably not less than 40 nm, however, not particularly limited thereto.

### EXAMPLES

Examples of the invention are given below by way of illustration and not by way of limitation.

### Examples 1 to 10

A reflective photomask blank (a reflective photomask blank of the first embodiment), as shown in FIG. 1, was manufactured by laminating a multilayer reflection film, a protection film, a light absorbing film, and a hard mask film in the order on a quartz substrate having dimensions of 152 mm square and about 6 mm thick.

First, the multilayer reflection film (having a reflectance of 65% with respect to light having a wavelength of 13.5 nm) that was a laminated film (thickness: 280 nm) in which molybdenum (Mo) layers and silicon (Si) layers were alternately laminated was formed on the quartz substrate with using a molybdenum target and a silicon target as targets, and argon gas (Ar gas) as a sputtering gas, by sputtering the molybdenum (Mo) target and the silicon (Si) target, alternately, with adjusting applied powers to the targets and a flow rate of the sputtering gas. The molybdenum (Mo) layers and the silicon (Si) layers were laminated 40 cycles (molybdenum (Mo) layers and silicon (Si) layers were 40 layers, respectively).

Next, a layer (thickness: 2 nm) consisting simple ruthenium (Ru) as a first layer of the protection film was formed on the multilayer reflection film with using a ruthenium (Ru) target as a target, and argon gas (Ar gas) as a sputtering gas, by sputtering the ruthenium (Ru) target with adjusting an applied power to the target and a flow rate of the sputtering gas.

Next, a layer (thickness: 2 nm) composed of tantalum oxide (TaO) or silicon oxide (SiO) as a second layer of the protection film was formed on the first layer of the protection film with using a tantalum (Ta) target or a silicon (Si) target as a target, and argon gas (Ar gas) and oxygen gas (O₂ gas) as sputtering gases, by sputtering with adjusting an applied power to the target and flow rates of the sputtering gases.

Next, a light absorbing film (thickness: 40 nm) composed of ruthenium oxynitride (RuON) was formed on the second layer of the protection film with using a ruthenium (Ru) target as a target, and argon gas (Ar gas), oxygen gas (O₂ gas) and nitrogen gas (N₂ gas) as sputtering gases, by sputtering with adjusting an applied power to the target and flow rates of the sputtering gases. The composition of the light absorbing film was 87 at% of ruthenium (Ru), 6 at% of oxygen (O) and 7 at% of nitrogen (N). Further, the light absorbing film had a reflectance (relative reflectance to the multilayer reflection film) of 15%, and a phase shift (relative phase shift to the multilayer reflection film) of 215 degrees, with respect to light having a wavelength of 13.5 nm.

Next, a hard mask film composed of silicon nitride (SiN) was formed on the light absorbing film with using a silicon (Si) target as a target, and argon gas (Ar gas) and nitrogen gas (N₂ gas) as sputtering gases, by sputtering with adjusting an applied power to the target and flow rates of the sputtering gases. As a result, the reflective photomask blank was obtained.

The composition of the second layer of the protection film, and the thickness and the composition of the hard mask film are shown in Table 1. In Examples, the compositions of the multilayer reflection film, the first and second layers of the protection film, the light absorbing film and the hard mask film were measured by an X-ray photoelectron spectrometer, and the thicknesses were measured by an X-ray diffractometer.

**Table 1**

| | Second Layer of Protection Film | | | Hard Mask Film | | |
|---|---|---|---|---|---|---|
| | Composition [at%] | | | Thickness [nm] | Composition [at%] | |
| | Tantalum (Ta) | Silicon (Si) | Nitrogen (N) | | Silicon (Si) | Nitrogen (N) |
| Example 1 | 0 | 32 | 68 | 10 | 75 | 25 |
| Example 2 | 0 | 32 | 68 | 2 | 75 | 25 |
| Example 3 | 0 | 32 | 68 | 16 | 75 | 25 |
| Example 4 | 40 | 0 | 60 | 10 | 75 | 25 |
| Example 5 | 0 | 32 | 68 | 10 | 50 | 50 |
| Example 6 | 0 | 80 | 20 | 10 | 75 | 25 |
| Example 7 | 0 | 32 | 68 | 17 | 75 | 25 |
| Example 8 | 0 | 32 | 68 | 10 | 85 | 15 |
| Example 9 | 0 | 90 | 10 | 10 | 75 | 25 |
| Example 10 | 90 | 0 | 10 | 10 | 75 | 25 |

### [Evaluation 1: Fluorine-based Dry Etching to Hard Mask Film]

With respect to each sample of the reflective photomask blanks obtained in Examples 1 to 10, a time (clear-time) for which the hard mask film disappears by fluorine-based dry etching was measured. The clear-time was measured as a time for which an end point was detected (a time until the end point) when the etching was performed to the hard mask film under the following conditions (Condition 1). After that, the etching was continued for a total etching time added with a 25% of the clear-time, then etching was completed. Clear-time, etching rate, and total etching time are shown in Table 2.

### [Conditions for Fluorine-based Dry Etching to Hard Mask Film (Condition 1)]

Apparatus: ICP (Inductively Coupled Plasma) System
Etching gas: SF₆ gas and He gas
Gas pressure: 4.0 mTorr (0.53 Pa)
ICP power: 400W

**Table 2**

| | Fluorine-based Dry Etching to Hard Mask Film | | |
|---|---|---|---|
| | Clear-Time [Second] | Etching Rare [nm/second] | Total Etching Time [Second] |
| Example 1 | 16.0 | 0.63 | 20 |
| Example 2 | 3.2 | 0.63 | 4 |
| Example 3 | 25.6 | 0.63 | 32 |
| Example 4 | 16.0 | 0.63 | 20 |
| Example 5 | 14.4 | 0.69 | 18 |
| Example 6 | 16.0 | 0.63 | 20 |
| Example 7 | 27.2 | 0.63 | 34 |
| Example 8 | 26.0 | 0.38 | 33 |
| Example 9 | 16.0 | 0.63 | 20 |
| Example 10 | 16.0 | 0.63 | 20 |

In Example 8, it is considered that the etching rate by fluorine-based dry etching was low because the hard mask film had a high silicon (Si) content.

### [Evaluation 2: Oxygen-Containing Chlorine-based Dry Etching to Light Absorbing Film]

With respect to each sample after performing Evaluation 1, a time (clear-time) for which the light absorbing film disappears by oxygen-containing chlorine-based dry etching was measured. The clear-time was measured as a time for which an end point was detected (a time until the end point) when the etching was performed to the light absorbing film under the following conditions (Condition 2). After that, the etching was continued for a total etching time added with a 100% of the clear-time, then etching was completed. Clear-time, etching rate, and total etching time are shown in Table 3. After etching, a thickness of the second layer of the protection film after etching of the light absorbing film was measured, and the reduced thickness of the second layer of the protection film was calculated. The result is shown in Table 3.

### [Conditions for Oxygen-Containing Chlorine-based Dry Etching to Light Absorber Film (Condition 2)]

Apparatus: ICP (Inductively Coupled Plasma) System
Etching gas: Cl₂ gas and O₂ gas
Gas pressure: 3.0 mTorr (0.40 Pa)
ICP power: 350W

**Table 3**

| | Oxygen-Containing Chlorine-based Dry Etching to Light Absorbing Film | | | |
|---|---|---|---|---|
| | Clear-Time [Second] | Etching Rare [nm/second] | Total Etching Time [Second] | Reduced Amount in Thickness of Second Layer [nm] |
| Example 1 | 204.0 | 0.20 | 408 | 0.2 |
| Example 2 | 204.0 | 0.20 | 408 | 0.2 |
| Example 3 | 204.0 | 0.20 | 408 | 0.2 |
| Example 4 | 204.0 | 0.20 | 408 | 0.1 |
| Example 5 | 204.0 | 0.20 | 408 | 0.2 |
| Example 6 | 204.0 | 0.20 | 408 | 0.6 |
| Example 7 | 204.0 | 0.20 | 408 | 0.2 |
| Example 8 | 204.0 | 0.20 | 408 | 0.2 |
| Example 9 | 204.0 | 0.20 | 408 | 1.2 |
| Example 10 | 204.0 | 0.20 | 408 | 0.5 |

In Example 9, it is considered that the reduced amount in thickness of the second layer of the protection film was large because the second layer of the protection film had a high silicon (Si) content, and a high etching rate in oxygen-containing chlorine-based dry etching.

### [Evaluation 3: Oxygen-Free Chlorine-based Dry Etching to Hard Mask Film]

With respect to each sample of the reflective photomask blanks obtained in Examples 1 to 10, a time (clear-time) for which the hard mask film disappears by oxygen-free chlorine-based dry etching was measured. The clear-time was measured as a time for which an end point was detected (a time until the end point) when the etching was performed to the hard mask film under the following conditions (Condition 3). Clear-time, and etching rate are shown in Table 4.

Next, with respect to each sample after performing Evaluation 2, a reduced amount of the second layer of the protection film by the over-etching in oxygen-free chlorine-based dry etching to the hard mask film was evaluated. A total etching time was a time added with 100% of the clear-time to the clear-time. The total etching time was shown in Table 4. Oxygen-free chlorine-based dry etching was performed to the second layer of the protection film under the following Condition 3 for the over-etching time shown in Table 4 that was the difference between the clear-time and the total etching time. After etching, the thickness of the second layer of the protection film was measured, and a reduced thickness of the second layer of the protection film was calculated. The result is shown in Table 4.

### [Conditions for Oxygen-Free Chlorine-based Dry Etching to Hard Mask Film (Condition 3)]

Apparatus: ICP (Inductively Coupled Plasma) System
Etching gas: Cl₂ gas
Gas pressure: 3.0 mTorr (0.40 Pa)
ICP power: 350W

**Table 4**

| | Oxygen-Free Chlorine-based Dry Etching to Hard Mask Film | | | |
|---|---|---|---|---|
| | Clear-Time [Second] | Etching Rare [nm/second] | Total Etching Time [Second] | Reduced Amount in Thickness of Second Layer [nm] |
| Example 1 | 114.8 | 0.087 | 230 | 0.1 |
| Example 2 | 23.0 | 0.087 | 46 | 0.1 |
| Example 3 | 183.7 | 0.087 | 367 | 0.1 |
| Example 4 | 114.8 | 0.087 | 230 | 0.1 |
| Example 5 | 106.8 | 0.094 | 214 | 0.1 |
| Example 6 | 114.8 | 0.087 | 230 | 0.3 |
| Example 7 | 195.2 | 0.087 | 390 | 0.1 |
| Example 8 | 143.5 | 0.070 | 287 | 0.3 |
| Example 9 | 114.8 | 0.087 | 230 | 0.7 |
| Example 10 | 114.8 | 0.087 | 230 | 1.1 |

In Examples 9 and 10, it is considered that the reduced amount in thickness of the second layer of the protection film was large because the second layer of the protection film had a high tantalum (Ta) or silicon (Si) content, and a high etching rate in oxygen-free chlorine-based dry etching.

### [Evaluation 4: Fluorine-based Dry Etching to Resist Film]

With respect to each of the reflective photomask blanks obtained in Examples 1 to 10, a reduced amount of a resist film by fluorine-based dry etching was evaluated.

First, a positive chemically amplified electron beam resist was spin-coated to form a resist film having a thickness of 60 nm.

Next, a total of 20 isolated line patterns having dimensions of a long side of 100 µm and a short side of 60 nm were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 40 seconds to form a resist pattern. Next, the hard mask film was subjected to fluorine-based dry etching with using the resist pattern as an etching mask under Condition 1 described above for the total etching time shown in Table 2 to form a pattern of the hard mask film.

Next, after etching the hard mask film, a thickness of the resist film was measured, and the reduced thickness of the resist film was calculated. The result is shown in Table 5. In Examples, the thickness of the resist pattern was measured by an atomic force microscope (AFM) within a range of a square area of 200 nm×200 nm as a measured range.

In the case that the remaining thickness of the resist pattern after etching is too thin, the fluorine-based plasma may reach the hard mask film and cause pinhole defects. Thus, a resist pattern having a specified thickness must be remained after fluorine-based dry etching to the hard mask film. From the reduced amount in the thickness of the resist film, the thickness of the resist film which was necessary for the resist pattern to remain at a thickness of 15 nm after fluorine-based dry etching of the hard mask film was calculated. The necessary thickness of the resist film for the resist pattern to remain at a thickness of 15 nm is shown in Table 5.

**Table 5**

| | Reduced Amount of Resist Film [nm] | Necessary Thickness of Resist Film [nm] |
|---|---|---|
| Example 1 | 28 | 43 |
| Example 2 | 6 | 21 |
| Example 3 | 45 | 60 |
| Example 4 | 28 | 43 |
| Example 5 | 25 | 40 |
| Example 6 | 28 | 43 |
| Example 7 | 48 | 63 |
| Example 8 | 46 | 61 |
| Example 9 | 28 | 43 |
| Example 10 | 28 | 43 |

### [Manufacture of Reflective Photomask]

To evaluate resolution limit of a fine pattern equivalent to an assist pattern of an isolated line pattern, a reflective photomask was manufactured from the reflective photomask blank.

First, a positive chemically amplified electron beam resist was spin-coated to form a resist film having a thickness shown in Table 6. The thickness of the resist film applied here was set to the above-described necessary thickness in the case that the thickness required for the resist pattern to remain at a thickness of 15 nm after fluorine-based dry etching of the hard mask film was not less than 40 nm, or the applied thickness of the resist film was set to 40 nm, which was the lower limit for the resist material used here to form a stable resist film thickness, in the case that the thickness required for the resist pattern to remain at a thickness of 15 nm after fluorine-based dry etching of the hard mask film was less than 40 nm. The applied thickness of the resist film is shown in Table 6.

Next, as a test pattern corresponding to an assist pattern of a line pattern, a total of 200,000 isolated line patterns having dimensions of a long side of 80 nm and a short side (width) of from 10 nm to 60 nm which varies by 1 nm, i.e., having a different dimension in the short side were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 40 seconds to form a resist pattern.

Next, the hard mask film was subjected to fluorine-based dry etching with using the resist pattern as an etching mask under Condition 1 described above for the total etching time shown in Table 2 to form a pattern of the hard mask film.

Next, the remaining resist pattern was removed by washing with a sulfuric acid-hydrogen peroxide mixture (SPM) which was a mixed solution of sulfuric acid and hydrogen peroxide solution in the volume ratio of sulfuric acid/hydrogen peroxide solution=3/1.

Next, the light absorbing film was subjected to oxygen-containing chlorine-based dry etching with using the pattern of the hard mask film as an etching mask under Condition 2 described above for the total etching time shown in Table 3 to form a pattern of the light absorbing film.

Next, the pattern of the hard mask film was subjected to oxygen-free chlorine-based dry etching under Condition 3 described above for the total etching time shown in Table 4 to remove the pattern of the hard mask film, then a reflective photomask was obtained.

Next, resolution limit of the test pattern of the obtained reflective photomask was evaluated by a mask visual inspection device. All isolated patterns were evaluated for pattern disappearance, pattern collapse, and pattern shape defects, and an isolated pattern having any of pattern disappearance, pattern collapse, and pattern shape defects detected by the visual inspection device was regarded as a defect, and the resolution limit was evaluated as the minimum dimension of the short side of the isolated pattern without the defect. Further, the thickness of the protection film (the thicknesses of the first layer and the second layer) was measured. The results are shown in Table 6.

**Table 6**

| | Thickness of Resist Film [nm] | Resolution Limit [nm] | Thickness of First Layer [nm] | Thickness of Second Layer [nm] | Thickness of Protection Film [nm] |
|---|---|---|---|---|---|
| Example 1 | 43 | 16 | 2 | 1.7 | 3.7 |
| Example 2 | 40 | 16 | 2 | 1.7 | 3.7 |
| Example 3 | 60 | 20 | 2 | 1.7 | 3.7 |
| Example 4 | 43 | 16 | 2 | 1.8 | 3.8 |
| Example 5 | 40 | 18 | 2 | 1.7 | 3.7 |
| Example 6 | 43 | 16 | 2 | 1.1 | 3.1 |
| Example 7 | 63 | 22 | 2 | 1.7 | 3.7 |
| Example 8 | 61 | 21 | 2 | 1.5 | 3.5 |
| Example 9 | 43 | 16 | 2 | 0.1 | 2.1 |
| Example 10 | 43 | 16 | 2 | 0.4 | 2.4 |

In Examples 1 to 6, 9 and 10, the clear time of fluorine-based dry etching is short, and the hard mask film is etchable by fluorine-based dry using a thin resist film. Even when the pattern has a narrow line width, the aspect ratio of the resist pattern is low and the resist pattern is unlikely to collapse, thus, the resolution limit is small.

On the other hand, in Example 7, the hard mask film was thick, and in Example 8, the hard mask film had a high silicon (Si) content and the etching rate by fluorine-based dry etching was low. Thus, it is considered that, in either case, a thicker resist film was required, the aspect ratio of the resist pattern was high, and the resist pattern was easy to collapse, thus, the resolution limit is large.

The invention is not limited to the above embodiment. The above-described embodiment is an example, and any other embodiment having the same or substantially the same configuration as the technical idea of the invention and having the same or similar effects can be regarded as the invention included in the scope of the inventive technical range.

## Claims

1. A reflective photomask blank comprising
a substrate,
a multilayer reflection film that is formed on the substrate and reflects exposure light being light in extreme ultraviolet range,
a protection film that is formed on the multilayer reflection film,
a light absorbing film that is formed on and in contact with the protection film and absorbs the exposure light, and
a hard mask film that is formed on and in contact with the light absorbing film, wherein
the protection film consists of a first layer that is provided at the substrate-side, and a second layer that is provided at the side remote from the substrate,
the second layer of the protection film is composed of a material that is resistant to dry etching capable of etching of the light absorbing film,
the light absorbing film has a phase shift function, and is formed of a single layer or multiple layers, and the single layer and each layer constituting the multiple layers are composed of a material comprising ruthenium (Ru) as a main component.

2. The reflective photomask blank of claim 1 wherein
the second layer of the protection film is composed of a material that is resistant to oxygen-containing chlorine-based dry etching, and
the light absorbing film is composed of a material that can be etched by oxygen-containing chlorine-based dry etching.

3. The reflective photomask blank of claim 2 wherein
the second layer of the protection film is composed of a material that is resistant to oxygen-containing chlorine-based dry etching and oxygen-free chlorine-based dry etching,
the light absorbing film is composed of a material that can be etched by oxygen-containing chlorine-based dry etching, and is resistant to oxygen-free chlorine-based dry etching and fluorine-based dry etching, and
the hard mask film is composed of a material that is resistant to oxygen-containing chlorine-based dry etching, and that can be etched by oxygen-free chlorine-based dry etching and fluorine-based dry etching.

4. The reflective photomask blank of claim 3 wherein the first layer of the protection film is composed of a material that is resistant to oxygen-free chlorine-based dry etching.

5. The reflective photomask blank of any one of claims 1 to 4 wherein the material comprising ruthenium (Ru) as a main component has a ruthenium (Ru) content of not less than 20 at%, and the ruthenium (Ru) has a highest atomic ratio with respect to the total of metal elements and metalloid elements.

6. The reflective photomask blank of any one of claims 1 to 5 wherein the light absorbing film has the phase shift function having, with respect to the exposure light, a reflectance of not less than 8% and not more than 28%, and a phase shift of not less than 180 degrees and not more than 240 degrees.

7. The reflective photomask blank of any one of claims 1 to 6 wherein the light absorbing film has a thickness of not less than 28 nm and not more than 50 nm.

8. The reflective photomask blank of any one of claims 1 to 7 wherein the second layer of the protection film is composed of a material comprising at least one selected from the group consisting of tantalum (Ta) and silicon (Si), and oxygen (O).

9. The reflective photomask blank of claim 8 wherein the hard mask film is composed of a material comprising silicon (Si) and nitrogen (N).

10. The reflective photomask blank of claim 9 wherein the first layer of the protection film is composed of a material comprising ruthenium (Ru).

11. The reflective photomask blank of any one of claims 1 to 10 wherein the second layer of the protection film has a thickness of not less than 1 nm and not more than 10 nm.

12. The reflective photomask blank of any one of claims 1 to 11 wherein the first layer of the protection film has a thickness of not less than 1 nm and not more than 6 nm.

13. The reflective photomask blank of any one of claims 1 to 12 wherein the hard mask film has a thickness of not less than 2 nm and not more than 16 nm.

14. A method for manufacturing a reflective photomask comprising the substrate, the multilayer reflection film, the protection film, and a pattern of the light absorbing film from the reflective photomask blank of claim 3 or 9, wherein
the method comprises the steps of:
(A) forming a resist film on and in contact with the hard mask film,
(B) patterning the resist film to form a resist pattern,
(C) patterning the hard mask film to form a pattern of the hard mask film by fluorine-based dry etching with using the resist pattern as an etching mask,
(D) removing the resist pattern,
(E) patterning the light absorbing film to form a pattern of the light absorbing film by oxygen-containing chlorine-based dry etching with using the pattern of the hard mask film as an etching mask, and
(F) removing the pattern of the hard mask film by oxygen-free chlorine-based dry etching.

15. The method of claim 14 wherein the resist film has a thickness of not more than 60 nm, and the pattern of the light absorbing film comprises a line pattern having a width of not more than 20 nm.
